# EUROPÄISCHE PATENTSCHRIFT

(11) **EP 2 976 932 B1**
(45) Veröffentlichungstag und Bekanntmachung des Hinweises auf die Patenterteilung: **04.01.2017**
(21) Anmeldenummer: 14712600.7
(22) Anmeldetag: 18.03.2014
(51) Int. Cl.: H05K 13/04

(54) **BESTÜCKKOPF ZUM BESTÜCKEN VON SUBSTRATEN MIT ELEKTRISCHEN BAUELEMENTEN IN EINER BESTÜCKVORRICHTUNG, VORRICHTUNG ZUM BESTÜCKEN VON SUBSTRATEN MIT ELEKTRISCHEN BAUELEMENTEN UND VERFAHREN ZUM BETREIBEN EINES BESTÜCKKOPFES**
FITTING HEAD FOR FITTING SUBSTRATES WITH ELECTRICAL COMPONENTS IN A FITTING DEVICE, DEVICE FOR FITTING SUBSTRATES WITH ELECTRICAL COMPONENTS AND METHOD FOR OPERATING A FITTING HEAD
TÊTE D'IMPLANTATION POUR IMPLANTER DES COMPOSANTS ÉLECTRIQUES SUR DES SUBSTRATS DANS UN DISPOSITIF D'IMPLANTATION, DISPOSITIF D'IMPLANTATION DE COMPOSANTS ÉLECTRIQUES SUR DES SUBSTRATS ET PROCÉDÉ POUR FAIRE FONCTIONNER UNE TÊTE D'IMPLANTATION

(30) Priorität: 19.03.2013 DE 102013004732
(43) Veröffentlichungstag der Anmeldung: 27.01.2016
(73) Patentinhaber: MIMOT GmbH, 79539 Lörrach (DE)
(72) Erfinder: MEHDIANPOUR, Mohamed, 81829 München (DE)
(74) Vertreter: Müller Hoffmann & Partner
(86) Internationale Anmeldenummer: PCT/EP2014/000735
(87) Internationale Veröffentlichungsnummer: WO 2014/146786

(56) Entgegenhaltungen:
- EP-A2- 2 081 424
- DE-A1- 10 129 352
- JP-A- 2002 176 293
- JP-A- 2007 305 887
- JP-A- 2010 278 037

## Beschreibung

Die vorliegende Erfindung betrifft einen Bestückkopf zum Bestücken von Substraten mit elektrischen Bauelementen in einer Bestückvorrichtung, eine Vorrichtung zum Bestücken von Substraten mit elektrischen Bauelementen und ein Verfahren zum Betreiben eines Bestückkopfes.

Die vorliegende Erfindung betrifft insbesondere einen Bestückkopf zum Bestücken von Substraten mit elektrischen Bauelementen in einer Bestückvorrichtung, wobei der Bestückkopf einen Führungskörper für zumindest einen Halter für die Bauelemente aufweist, an dem der Halter in einer zum Substrat senkrechten Hubrichtung verschiebbar gelagert ist, wobei der Halter aus einer oberen Halteposition in die Richtung des Substrats nach unten verschiebbar ist, wobei der Halter mit einem in der senkrechten Richtung verschiebbaren Hubaktor elektromagnetisch derart koppelbar ist, dass eine auf den Halter nach unten gerichtete Hubkraft über eine magnetische Haftkraft übertragbar ist, wobei die Haftkraft an einer Stirnfläche eines beschaltbaren elektromagnetischen Spulenteils wirkt, das durch den Hubaktor in der Hubrichtung verschiebbar ist und wobei an die Stirnfläche ein ferromagnetisches Gegenstück anlegbar bzw. von der Stirnfläche abhebbar ist.

In der Bestücktechnik ist es üblich, mit einem Bestückkopf Bauelemente mit weit unterschiedlichen Aufsetzkräften auf Leiterplatten zu bestücken. Insbesondere darf bei kleinen und empfindlichen Bauelementen eine zulässige Aufsetzkraft nicht überschritten werden. Ferner erfordern gerade große und zu klebende Bauelemente eine erhöhte Mindestkraft. Des Weiteren gibt es elektromechanische Bauelemente, z.B. Steckverbinder, deren Anschlüsse mit relativ hoher Kraft in Bohrungen der Leiterplatte eingedrückt werden müssen. Kleine Bauelemente werden in einer sehr hohen Anzahl montiert. Sie erfordern einen leistungsfähigen Bestückkopf mit einer Mehrzahl von Haltern.

Die US5285946A beschreibt einen Bestückkopf, bei dem im Bereich einer Halterspitze eine Kraftmesseinrichtung angebracht ist, die die Aufsetzkraft detektiert. Mit diesen Messwerten wird in einem Regelkreis die Antriebskraft eines Hubantriebs gesteuert. Die hohen Massenkräfte der bewegten Teile verzögern dabei die Regelzyklen und beeinträchtigen die Genauigkeit.

Aus der EP1075174A ist ein Bestückkopf mit einem Druckzylinder bekannt, der eine pneumatische Feder darstellt, durch die die Aufsetzkraft entsprechend dem voreingestellten Zylinderdruck auf einen vorgegebenen Wert begrenzt werden kann. Die pneumatische Einrichtung mit dem Zylinder, dem erforderlichen Regelventil und dem Drucksensor ist relativ komplex. Das komprimierbare Medium lässt sich nicht ohne Verzögerung regeln. Der pneumatische Kolben kann nach oben ausfedern, so dass Höhenabweichungen zwischen der Substratoberfläche und der Halterspitze ausgeglichen werden können.

Die US6293006B beschreibt einen Bestückkopf, bei dem ein senkrecht verschiebbarer Halter für ein Bauelement durch eine elektrisch betätigbare Klemmgabel in seiner oberen Ruhestellung lösbar fixiert werden kann. Solange der Halter aus seiner oberen Ruhestellung entfernt ist, muss die Klemmgabel elektrisch betätigt bleiben.

Die JP2007305887 lehrt einen Bestückkopf mit einer Mehrzahl von Haltern für die Bauelemente. Die Halter sind in einem Rotor senkrecht verschiebbar und drehfest gelagert. Sie sind in gleicher Winkelteilung konzentrisch um die senkrechte Rotorachse verteilt. Die erforderliche Winkeldrehung der Bauelemente wird durch eine entsprechende Drehung des Rotors und durch eine x-y-Lagekorrektur der Rotorachse gegenüber dem Substrat erreicht. Ein solcher Bestückkopf muss daher relativ zum Substrat verschiebbar sein. Die Halter befinden sich im unbetätigten Zustand unter der Vorspannung von Rückstellfedern in einer oberen Ruhestellung. Sie sind an ihren oberen Enden mit radial abstehenden ferromagnetischen Koppelelementen versehen. Unterhalb der Koppelelemente sind Spulenteile angeordnet, die mit ihrer oberen Stirnfläche den Koppelelementen zugewandt sind. Die Spulenteile sind auf ihrer Unterseite auf einem gemeinsamen Hubelement eines Hubaktors befestigt, wobei das Hubelement mit dem Rotor drehfest verbunden und senkrecht zu diesem verschiebbar ist.

Das Hubelement kann so weit nach oben verschoben werden, dass sich die obere Stirnfläche der Spulenteile an die untere Seite der Koppelelemente anlegt. Die Spulenteile können selektiv und einzeln bestromt werden, so dass zu dem jeweiligen Koppelelement eine kraftschlüssige Verbindung aufgebaut wird, wobei die magnetische Haftkraft größer ist als die maximale Federkraft der Rückstellfedern. Beim Absenken des Hubelementes wird der zugeordnete Halter zunächst zum Substrat hin beschleunigt und danach abgebremst, wobei die gesamte bewegte Masse des Hubaktors mit den Spulenteilen und dem Halter abgefangen werden muss. Die Aufsetzkraft könnte dann über die Stromzufuhr zum Hubantrieb des Hubaktors gesteuert werden. Selbst in einer üblicherweise stark verlangsamten Annäherungsphase würden dabei die hohe Federkraft der Rückstellfeder, das hohe Eigengewicht und die entsprechenden Massenkräfte der beweglichen Teile des Hubaktors die Aufsetzkraft überlagern, was einen genauen Abgleich erschwert.

Aus der JP 2002 176293 A ist ein Bestückkopf mit einem Führungskörper bekannt, in dem ein einzelner Halter mithilfe von zwei Elektromagneten in einer oberen und einer unteren Halteposition gehalten werden kann.

In der EP 2081424 A2, der JP 2010 278037 A und der DE 101 29352 A1 sind weitere Bestückköpfe beschrieben.

Der Erfindung liegt die Aufgabe zu Grunde, einen Bestückkopf der eingangs genannten Art sowie eine Vorrichtung zum Bestücken und ein Verfahren zum Betreiben eines derartigen Bestückkopfes zu schaffen, bei welchen der sich ergebende Bestückablauf beschleunigt werden kann und bei welchen insbesondere die Aufsetzkraft der Bauelemente auf das Substrat sicher in einem engen Toleranzbereich gehalten werden kann.

Die der Erfindung zu Grunde liegende Aufgabe wird bei einem Bestückkopf erfindungsgemäß mit den Merkmalen des Anspruchs 1, bei einer Vorrichtung zum Bestücken erfindungsgemäß mit den Merkmalen des Anspruchs 14 und bei einem Verfahren zum Betreiben eines Bestückkopfes erfindungsgemäß mit den Merkmalen des Anspruchs 15 gelöst. Vorteilhafte Weiterbildungen sind Gegenstand der jeweiligen abhängigen Ansprüche.

Die Erfindung ermöglicht eine genaue Kontrolle des Aufsetzvorganges des Bauelements auf das Substrat ohne hohen Mess- und Regelaufwand. Zu Beginn eines Absenkzyklus des Halters ist der Hubaktor so weit angehoben, dass sich das z.B. am Halter angebrachte ferromagnetische Gegenstück an die Stirnfläche des z.B. als elektrischer Haftmagnet ausgebildeten Spulenteils anlegt. Die magnetische Haftkraft zwischen dem Spulenteil ist größer als die maximale Beschleunigungskraft beim Absenken des Halters. Dadurch wird eine definierte kraftschlüssige Verbindung zwischen dem Halter und dem Hubaktor hergestellt und der angekoppelte Halter mit diesem nach unten bewegt. Beim Annähern des an der Halterspitze anliegenden Bauelements an die Oberfläche des Substrats wird die magnetische Haftkraft am Spulenteil auf einen vorgegebenen Wert abgesenkt und der Hubaktor wird abgebremst. Beim Auftreffen des Bauelementes auf dem Substrat hebt sich das ferromagnetische Gegenstück vom Spulenteil ab. Der Hubaktor kann aber noch weiter durchschwingen und muss nicht abrupt abgebremst werden.

Durch die magnetische Haftkraft ist sichergestellt, dass die Aufsetzkraft den eingestellten Wert sicher erreicht und der Halter vom Hubaktor vollständig entkoppelt wird, wodurch die wirkenden Massen- und Gewichtskräfte weitgehend eliminiert werden. Die geringe Restmasse das Halters ermöglicht eine höhere Auftreffgeschwindigkeit und eine kürzere Zyklusdauer. Durch die haftmagnetische Ausbildung des Spulenteils wird bei geringer Baugröße eine hohe Magnetkraft erreicht. Es kommt bereits bei einem geringen Spaltabstand zum Gegenstück zu einem starken Abfall der Magnetkraft. Damit wird bereits nach einem kurzen Hub eine nahezu vollständige Entkopplung erreicht werden, so dass die Weiterbewegung des Hubaktors auf eine entsprechend kurze Umkehrstrecke begrenzt werden kann.

Die Änderung des Magnetfelds nach Anspruch 2 entsteht besonders deutlich beim Abheben de Gegenstücks vom Spulenteil. Dies führt zu starken Schwankungen in der Stromzuführung, was sich in einfacher Weise durch einen Stromsensor detektieren lässt. Damit ist es möglich, den Moment des Aufsetzens des Bauelements auf das Substrat einfach und sicher zu erfassen und den Hubvorgang umzukehren.

Durch die Weiterbildung nach Anspruch 2 kann die senkrechte Hubbewegung des Hubkörpers in einfacher Weise axial spielfrei auf das Hubelement und damit auf den Hubaktor mittels des z.B. als Rillenkugellager ausgebildeten Drehlagers übertragen werden, bei dem die Lagerelemente in sich axial und radial vorgespannt sind.

Das nach Anspruch 3 am Halter verankerte ferromagnetische Koppelteil mit der waagerecht abstehenden Schulter kann erheblich leichter ausgebildet sein als das Spulenteil, wodurch mit dem Halter verbundene Zusatzmasse gering bleibt.

Durch die Kippbarkeit nach Anspruch 4 ist es möglich, dass sich die Schulter des Spulenteils und die Stirnfläche des Koppelteil auch bei nicht paralleler Ausgangsstellung vollflächig aneinanderlegen können, so dass bei einer Kippbarkeit um zwei Achsen eine stets gleiche magnetische Haftkraft erreicht werden kann.

Bei der Weiterbildung nach Anspruch 5 erfolgt die Krafteinleitung in den vorzugsweise zylindrischen Halter zentral, also frei von Kippmomenten. Das bedeutet, dass am Halter keine seitlichen Führungs- und Reibungskräfte auftreten. Bei einem von Spulenteil abgehobenen Koppelteil ist es möglich, den Halter um seine eigene Mittelachse zu drehen, um das gehaltene Bauelement in einer richtigen Winkellage auf das Substrat aufsetzen zu können.

Das Kugelgelenk nach Anspruch 6 kann z.B. eine am Halter fixierte Mittelkugel aufweisen, auf der das zweiteilige Koppelteil in einfacher Weise gelagert ist.

Bei der Anordnung nach Anspruch 7 kann das mit dem Halter verbundene Koppelteil als leichtes Plättchen ausgebildet werden, so dass die mit dem Halter zu bewegende Masse gering bleibt.

Die Kenndaten nach Anspruch 8 können z.B. die Magnetkraftlinie in Abhängigkeit von der Stromstärke wiedergeben. Diese Werte können bei verschiedenen Koppelpaaren auf Grund geometrischer Abweichungen insbesondere in der Oberflächenbeschaffenheit unterschiedlich ausfallen. Diese Daten können z.B. in einer externen Messeinrichtung ermittelt und im Datenspeicher des Bestückkopfes gespeichert werden. Nach jedem Wechsel des Bestückkopfes in einer Bestückvorrichtung können diese Daten ausgelesen und bei der Steuerung der Aufsetzkraft genutzt werden. Durch die individuellen Kenndaten ist es auch möglich, bei einem Bestückkopf mit mehreren Haltern und den verschiedenen elektromagnetischen Koppelpartnern gleiche Kraftverhältnisse herzustellen.

Durch die Haltemittel nach Anspruch 9 kann der leichte Halter in seiner oberen Hubstellung lösbar gehalten werden. Dabei kann die geringe Haltekraft z.B. durch eine einfache Rastverbindung aufgebracht werden. Nach der Trennung von den Haltemitteln wird damit die Haltekraft unwirksam und beeinflusst nicht mehr den weiteren Bestückablauf und die Aufsetzkraft.

Der Permanentmagnet nach Anspruch 10 hält den Halter durch einfachen magnetischen Kraftschluss in seiner oberen Lage, in der er z.B. mit dem Koppelteil am Führungskörper verdrehsicher anliegt. Die Anziehungskraft des Spulenteils kann erheblich höher sein als die Haltekraft des Permanentmagneten. Besonders vorteilhaft ist hier, dass die Übergabe der Koppelteile an die Spulenteile unter stetigem Kraftschluss spielfrei erfolgt, so dass die Drehlage des z.B. zylindrisch gelagerten Halters nicht verändert wird. Da das Hubelement am Rotor drehfest gelagert ist, wird auch beim Absenken des Hubelementes die Drehlage des Halters nicht verstellt, so dass der Halter im Rotor keine präzise Drehsicherung benötigt.

Die elektrische Steuerung nach den Ansprüchen 11 und 12 enthält elektronisch regelbare Steuerelemente zum Verändern der Stromwerte der einzelnen Leitungen zu den Spulenteilen. Es ist vorteilhalt, die Steuerelemente dem Bestückkopf unmittelbar zuzuordnen. Dabei kann eine elektronische Platine des Bestückkopfes nicht nur die Steuerelemente, sondern auch die Stromsensoren und den Speicher für die Kenndaten aufweisen. Es ist aber auch möglich, die Steuerung an einem Träger anzuordnen, an dem der Bestückkopf befestigbar ist, dessen Leitungen direkt an die Steuerung angeschlossen werden können. Damit bilden dann der Bestückkopf und die Steuerung eine komplette Funktionseinheit.

Durch die Weiterbildung nach Anspruch 13 ist es möglich, einen gemeinsamen Hubaktor für mehrere Halter eines Bestückkopfes vorzusehen und in einfacher Weise mit den Haltern wahlweise kraftgesteuert zu koppeln, so dass mit geringem mechanischem Aufwand alle Aufsetzvorgänge im Hinblick auf die Aufsetzkraft kontrolliert werden können.

Das Hubelement nach Anspruch 14 kann z.B. durch eine Nut-Feder-Verbindung drehfest mit dem Rotor gekoppelt sein, wobei die senkrechte Verschiebbarkeit des Hubelementes gegenüber dem in dieser Richtung fixierten Rotor gewährleistet ist. Für das Hubelement ist kein eigener Drehantrieb erforderlich. Es muss jeweils nur das Spulenteil aktiviert werden, das dem abzusenkenden Halter zugeordnet ist. Die übrigen Halter können durch die einfachen Haltemittel in ihrer oberen Hubstellung fixiert werden. Der Steuerungsaufwand und der mechanische Betätigungsaufwand sind entsprechend gering. Durch die rotatorische Kopplung des Hubelements und des Rotors bleiben auch die einzelnen Koppelpartner der Koppelelemente in ihrer Winkellage einander fest zugeordnet.

Die Weiterbildung nach Anspruch 15 hat den Vorteil, dass die einzelnen Leitungen zu den Spulenteilen keiner drehenden Schleppbewegung unterworfen sind. Bei der Zuordnung zum Hubelement entfällt sogar die Hubbewegung. Alle für die Hubkraftsteuerung erforderlichen elektrischen Bauteile können auf einer gemeinsamen Leiterplatte angeordnet und verschaltet sein. Von außen müssen lediglich die Stromversorgung und elektronische Datenleitung angeschlossen werden.

Durch die Weiterbildung nach Anspruch 16 kann die senkrechte Hubbewegung des Hubkörpers in einfacher Weise axial spielfrei auf das Hubelement und damit auf den Hubaktor mittels des z.B. als Rillenkugellager ausgebildeten Drehlagers übertragen werden, bei dem die Lagerelemente in sich axial und radial vorgespannt sind.

Durch die Weiterbildung nach Anspruch 17 kann der z.B. als Linearmotor ausgebildete Hubantrieb komplett außerhalb des Bestückkopfes angeordnet werden. Dadurch wird der Bestückkopf vom Hubantrieb thermisch weitgehend entkoppelt und die Abwärme des freiliegenden Hubantriebs kann leicht an die umgebende Atmosphäre abgegeben werden. Die Anordnung des Hubabtriebs außerhalb des Bestückkopfes schafft ferner konstruktiven Freiraum für den Aufbau des Bestückkopfes selbst, der damit erheblich einfacher gestaltet werden kann als mit integriertem Hubantrieb. Der Hubantrieb kann neben dem Bestückkopf parallel zu diesem angeordnet werden, so dass die Gesamtbauhöhe beider Komponenten niedrig bleiben kann.

Das Schnellkoppelelement nach Anspruch 18 ermöglicht eine einfache An- und Abkopplung des Bestückkopfes mit dem Hubantrieb, der im Falle einer Auswechslung des Bestückkopfes an Ort und Stelle verbleiben kann. Die schmale Ringnut benötigt nur eine geringe Eingriffshöhe, so dass sich die Bauhöhe des Bestückkopfes für die Ankoppelung des Hubantriebs nur wenig erhöht.

Bei dem Bestückkopf nach Anspruch 19 hält der Permanentmagnet den Halter durch einfachen magnetischen Kraftschluss in seiner oberen Lage, wobei die permanentmagnetische Haltekraft nur geringfügig größer sein muss als das Eigengewicht des Halters mit den daran verankerten Magnetteilen. Zum Lösen der Fixierung muss nur eine geringe Absenkkraft über eine geringe Wegstrecke aufgebracht werden. Eine aktive Beeinflussung des Haltemechanismus ist nicht erforderlich. Nach dem Lösen der Halteverbindung reißt die magnetische Haltekraft schnell ab und der weitere Absenkvorgang wird nicht mehr beeinflusst, so dass auch die Aufsetzkraft unbeeinflusst bleibt. Die Anziehungskraft des Spulenteils ist erheblich höher als die Haltekraft des Permanentmagneten, so dass die Fixierung ohne jeden Mehraufwand gelöst werden kann. Es ist vorteilhaft, den Permanentmagneten am Führungskörper und das weichmagnetische Ankerteil am Halter zu befestigen, so dass der Permanentmagnet oben bleibt und die elektromagnetische Haftwirkung zwischen dem abgesenkten Spulenteil und dem Koppelteil nicht mehr nennenswert beeinflusst wird. Damit kann die Aufsetzkraft des Bauelements auf das Substrat genauer und schneller geregelt werden.

Bei der ringförmigen Ausbildung der Magnetteile nach Anspruch 20 werden diese teleskopartig ineinander gezogen und es wird der Halter in einer oberen nachgiebigen Schwebestellung gehalten, so dass sich die Spulenteile auch bei geringen Höhenunterschieden vollständig an die Koppelteile anlegen können. Die ringförmig mit Spiel ineinandergreifenden Magnetteile können sich frei gegeneinander verdrehen. Damit ist es auch möglich, den zylindrischen Halter im Führungskörper zu verdrehen, um die Winkellage des Bauelements korrigieren zu können.

Die Vorrichtung nach Anspruch 21 ermöglicht die schnelle vollständige Bestückung des Substrats mit den Bauelementen unter genauer Einhaltung der zulässigen Aufsetzkräfte

Durch die Weiterbildung nach Anspruch 22 kann der Hubkörper schnell wechselbar mit dem separaten Hubantrieb gekoppelt werden. Dadurch ist es auch möglich, verschiedene Varianten des Bestückkopfes, z.B. mit verringerter Halteranzahl am Träger anzubringen, ohne den Hubantrieb wechseln zu müssen.

Durch das Verfahren nach Anspruch 23 ist es möglich, den Bestückkopf so zu betreiben, dass bei beschleunigtem Bestückablauf die Aufsetzkraft der Bauelemente auf das Substrat sicher und in einem engen Toleranzbereich gehalten werden kann.

Im Folgenden wird die Erfindung an Hand eines in der Zeichnung dargestellten Ausführungsbeispieles näher erläutert. Es zeigen:
- **Fig. 1**: eine perspektivische Ansicht eines Trägers mit einem Bestückkopf und einem Hubantrieb,
- **Fig. 2**: einen Schnitt durch den Bestückkopf und den Träger entlang den Linien II-II in Fig. 1,
- **Fig. 3**: eine vergrößerte Einzelheit III in Fig. 2,
- **Fig. 4**: einen Teil des Bestückkopfes nach Figur 2 in einer anderen Funktionsstellung,
- **Fig. 5**: einen Querschnitt durch den Bestückkopf entlang der Linie V - V in Fig. 4,
- **Fig. 6**: einen vergrößerten Schnitt durch einen abgewandelten Bestückkopf analog Figur 4 in eine Funktionsphase,
- **Fig. 7**: einen Querschnitt durch den Bestückkopf entlang der Linie VII - VII in Fig. 6,
- **Fig. 8**: einen Teil Bestückkopfes nach Fig. 6 in einer nachfolgenden Funktionsphase.

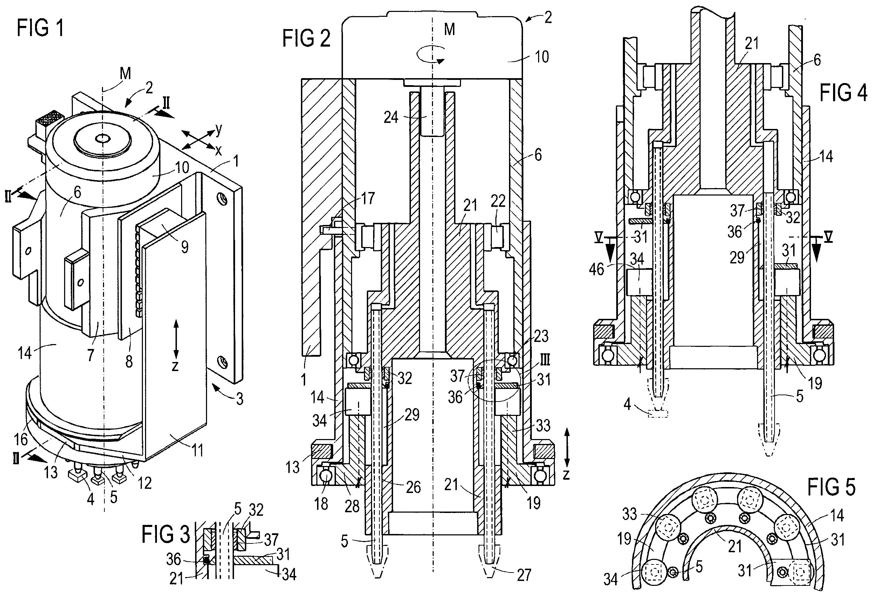

Fig. 1 zeigt einen Träger 1 mit einem daran befestigten Bestückkopf 2 und einem Hubantrieb 3. Der Träger 1 kann mit seiner dem Bestückkopf 2 abgewandten Rückseite an einer Linearführung eines Bestückautomaten gelagert sein, durch die er in einer waagerechten Längsrichtung x verschiebbar ist. Die Linearführung kann an einem in einer waagerechten Querrichtung y verschiebbaren Bestückarm ausgebildet sein, so dass der Träger 1 mit dem Bestückkopf 2 zwischen verschiedenen Arbeitsbereichen des Bestückautomaten verfahrbar ist. Ein solcher Arbeitsbereich kann z.B. ein Abholbereich für elektrische Bauelemente 4 oder ein waagerechtes Bestückfeld sein, in dem ein mit den Bauelementen 4 zu bestückendes Substrat 38 flachliegend fixierbar ist. Es ist aber auch möglich, die Linearführung stationär auszubilden und das Substrat 38 auf einem Tisch zu fixieren, der in der Querrichtung y verschiebbar ist.

Der Bestückkopf 2 hat im Wesentlichen eine um eine senkrechte Mittelachse M rotationssymmetrische Struktur. Auf der Unterseite des Bestückkopfes 2 ragen zur Mittelachse M konzentrisch verteilte, in einer senkrechten Richtung z einzeln verschiebbare zylindrische Halter 5 für die Bauelemente 4 heraus. Ein Gehäuse 6 des Bestückkopfes 2 weist eine zylindrische Mantelfläche auf. Auf der Oberseite des Gehäuses 6 ist ein Drehmotor 10 koaxial zur Mittelachse M angebracht.

Der Träger 1 umgreift mit zwei schellenartigen Klemmbügeln 7 die zylindrische Mantelfläche des Gehäuses 6, das z.B. mittels einer Klemmschraube mit den Klemmbügeln 7 verspannt ist, wodurch der Bestückkopf 2 in einer definierten Lage am Träger 1 befestigt ist.

Der als Linearmotor ausgebildete Hubantrieb 3 besteht aus einer neben dem Bestückkopf 2 am Träger 1 fixierten Magnetschiene 8 und einem in der senkrechten Richtung z verschiebbaren Spulenträger 9, das in einer nicht dargestellten Führung des Trägers 1 gelagert ist. Am Spulenträger 9 ist ein bewegbares Antriebsteil 11 befestigt, das mit einem zum Bestückkopf 2 hin abgewinkelten gabelartigen Koppelelement 12 mit bügelartigen Koppelfingern 13 versehen ist. In seinem unteren Bereich weist der Bestückkopf 2 einen in der senkrechten Richtung z verschiebbaren im Wesentlichen hohlzylindrischen Hubkörper 14 auf, der an seinem unteren Ende mit einer nach außen offenen Ringnut 16 versehen ist, in die die Koppelfinger 13 tangential eingeschoben sind, wodurch eine senkrechte Hubbewegung des Koppelteils 12 spielfrei auf den Hubkörper 14 übertragen werden kann.

Nach den Fig. 2, 3, 4 und 5 ist der Hubkörper 14 an der zylindrischen Mantelfläche des Gehäuses 6 in dessen unteren Bereich geführt, wobei nicht näher dargestellte Eingriffsmittel eine grobe Verdrehung des Hubkörpers verhindern. Das Gehäuse 6 weist am oberen Rand des Hubkörpers 14 einen radial nach außen vorstehenden Stift 17 auf, der in eine bajonettverschlussartige Nut des Trägers 1 eingreift und das im wesentlichen hohlzylindrische Gehäuse 6 fixiert.

Der Hubkörper 14 ist an seinem unteren Ende über ein zur Mittelachse M konzentrisches Drehlager 18 mit einem in seinem Innenraum angeordneten Hubelement 19 gekoppelt, wodurch eine Hubbewegung des Hubkörpers 14 spielfrei auf das Hubelement 19 übertragen wird. Der Hubantrieb 3, der Hubkörper 14 und das Hubelement 19 bilden einen Hubaktor für die Halter 5.

Der Bestückkopf 2 weist im Innenraum des Gehäuses 6 und des Hubkörpers 14 einen zur Mittelachse konzentrischen länglichen Rotor 21 auf, der mittels Wälzlagern 22, 23 am Gehäuse 6 drehbar gelagert ist und der mit einer Antriebswelle 24 des Drehmotors 10 drehfest gekoppelt ist. Der in der senkrechten Richtung lagefixierte Rotor 21 ist in seinem unteren Bereich mit nach unten offenen Bohrungen 26 versehen, die um die Mittelachse M konzentrisch verteilt und parallel zu dieser ausgerichtet sind und die die röhrchenartigen Halter 5 aufnehmen. Diese können an ihrem unteren, aus dem Rotor herausragenden Ende mit jeweils einem wechselbaren Saugadapter 27 für das Bauelement 4 versehen sein. Das Hubelement 19 umgreift mit einer ringförmigen Basis 28 das untere Ende des Rotors 21 und ist mit diesem durch nicht näher dargestellte Führungsmittel drehfest, aber axial verschiebbar gekoppelt.

Der Rotor 21 weist im mittleren Längenbereich der Halter 5 eine nach außen offene ringförmige Freimachung 29 auf, die Bewegungsraum für am Halter 5 befestigte ferromagnetische Koppelteilen 31 ermöglicht. Die radial vom Halter 5 nach außen abstehenden plättchenförmigen Koppelteile 31 ragen über das Hubelement 19. Dieses ist mit von der Basis 28 nach oben ragenden schlanken Stützelementen 33 versehen, an deren oberen Enden Spulenteile 34 befestigt sind, die durch Anheben des Hubelements 19 jeweils mit ihrer nach oben weisenden waagerechten Stirnfläche 46 auf die Unterseite der zugehörigen Koppelteile 31 aufsetzbar sind, die zusammen mit den Spulenteilen 34 schaltbare Koppelelementpaare bilden, durch welche die einzelnen Halter 5 wahlfrei mit dem Hubelement koppelbar und ab oder auf bewegbar sind.

Jeweils ein Halter 5 mit seinem Koppelteil und dem zughörigen Spulenteil 34 bilden ein im Folgenden näher beschriebenes Kopfsegment. Durch Bestromen des Spulenteils 34 wird eine hinreichend große magnetische Anziehungskraft erzeugt, um das Koppelteil 31 auch beim stark beschleunigten Absenken des Hubelementes 19 sicher am Spulenteil 34 fixieren zu können. Oberhalb des Koppelteils 31 ist im Rotor 21 ein den Halter 5 ringförmig umgreifender Permanentmagnet 32 angeordnet. An dem aus nichtmagnetischem Material bestehenden Halter 5 ist konzentrisch ein hülsenförmiges ferromagnetisches Ankerteil 37 befestigt, das als Rückschlusshülse dient und in seiner oberen Hubstellung in den Permanentmagnet 32 eintaucht. Eine derartige Anordnung ergibt bereits zu Beginn des Eintauchens eine hohe magnetische Anziehungskraft, die über eine längere Wegstrecke konstant bleibt und sich erst beim Annähern an eine gegenseitige Mittelstellung gegen Null verringert. Durch eine entsprechende festgelegte Anschlaghöhe des Halters 5 am Rotor 21 kann eine geringe Endkraft eingestellt werden, die im Gegensatz zu einem Haftmagneten einen harten Aufschlag vermeidet.

Da eine hinreichende Anziehungskraft bereits deutlich vor der oberen Endstellung des Halters 5 erreicht wird, kann das Spulenteil 34 entsprechend früher abgeschaltet werden. Den Antrieb für den Resthub übernimmt der Permanentmagnet 32. Das frühzeitige Abschalten des Spulenteils 34 lässt dessen Magnetfeld soweit zusammenfallen, dass beim unmittelbar anschließenden Absenken die Haltekraft des Permanentmagneten 32 überwiegt und der Halter 5 sicher in der oberen Stellung verbleibt. Besonders vorteilhaft ist hier, dass die Übergabe des Koppelteils 31 an den Spulenteilen 34 unter stetigem Kraftschluss spielfrei erfolgt, so dass die Drehlage des z.B. zylindrisch gelagerten Halters 5 nicht verändert wird. Da das Hubelement 19 am Rotor 21 drehfest gelagert ist, wird auch beim Absenken des Hubelementes 19 die Drehlage des Halters 5 nicht verstellt, so dass der Halter 5 im Rotor 21 keine präzise Drehsicherung benötigt.

Das Koppelteil 31 umgreift den Halter 5 mit seinem inneren Ende und ist mit diesem stoffschlüssig z.B. durch Hartlöten verbunden. Die innere Stirnseite des Koppelteils 31 verläuft mit geringem Abstand konzentrisch zum Rotor 21 und ist sich hohlkegelförmig nach oben erweiternd abgeschrägt. In eine Ringnut des Rotors 21 ist ein elastomerer O-Ring 36 eingesetzt, an den die innere Stirnseite des Koppelteils 31 unter der Hubkraft des Permanentmagneten 32 anschlägt und somit am Rotor 21 in einer definierten Winkellage zentriert und bis zum Absenken durch das Spulenteil 34 gehalten wird.

Fig. 2 zeigt den Bestückkopf 2 mit dem in seiner oberen Hubstellung befindlichen Hubelement 19, wobei die Spulenteile 34 an den Koppelteilen 31 anschlagen. Die Fig. 4 und 5 zeigen den Bestückkopf 2 mit dem abgesenkten Hubelement 19. Dabei ist eines der Spulenteile 34 eingeschaltet und der zugehörige Halter 5 mitgenommen worden, um eines der Bauelemente 4 von einem Bereitstellplatz abholen oder auf ein Substrat 38 aufsetzen zu können.

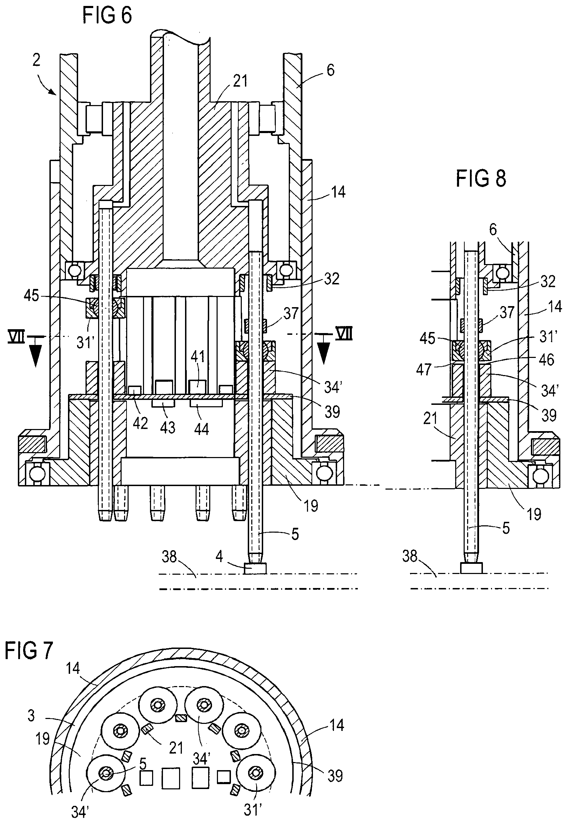

Der Bestückkopf 2 nach den Figuren 6 bis 8 unterscheidet sich von dem Bestückkopf 2 im Wesentlichen durch angeordnete und ausgebildete Spulenteile 34', Koppelteile 31'. Diese sind zylindrisch ausgebildet und umschließen den zylindrischen Halter 5 drehsymmetrisch. Die Spulenteile 34' weisen eine zylindrische zentrale Bohrung als Freimachung für den Halter 5 auf. Oberhalb des Spulenteils 34' ist am Haltermantel eine Mittelkugel 45 befestigt, die als Schwenklager für das umschließende Koppelteil 31' dient. Durch dieses Kugelgelenk kann sich das Koppelteil 31' mit seiner unteren Schulterfläche 47 vollständig an die obere Stirnfläche 46 des Spulenteils 34' anlegen, so dass stets gleichbleibende Haftbedingen vorliegen und die gewünschte Aufsetzkraft des Bauelements 4 genau eingestellt werden kann.

Auf der Oberseite des Hubelements 19 ist eine Leiterplatte 39 befestigt, auf der die Spulenteile 34' fixiert und elektrisch angeschlossen sind. Die Leiterplatte 39 trägt ferner Steuerelemente 41, durch die die Stromzufuhr zu den Spulenteilen 34' variiert werden kann. Auf der Leiterplatte sind ferner Stromsensoren 42, ein Speicherbaustein 43 und ein Elektronikchip 44 angeschlossen. Das bedeutet, dass alle Elemente dieser Steuerung mit geringem Aufwand sicher mit einander gekoppelt sind. Die Stromsensoren 42 überwachen die Stromzufuhr zu den Spulenteilen 34'. Im als Datenspeicher dienenden Speicherbaustein 43 sind zu jedem Spulenteil 34' die Kenndaten bezüglich der Aufsetzkräfte abgespeichert. Der Elektronikchip 44 ist mit den übrigen Bauteilen sowie mit einer externen Steuerelektronik verknüpft, die den für jedes Bauelement 4 zulässigen Wert der Aufsetzkraft liefert. Es versteht sich, dass eine entsprechende Elektronikbaugruppe auch in dem Bestückkopf nach den Figuren 2 bis 5 eingesetzt sein kann.

Nach Fig. 6 ist das Hubelement 19 aus einer oberen Hubstellung analog Fig. 2 in die dargestellte Zwischenstellung abgesenkt. Dabei ist eines der Spulenteile 34' an die Stromzufuhr angeschlossen und hat das zugehörige Koppelteil 31' und den damit verbundenen Halter 5 mitgenommen. Gezeigt ist der Moment des Aufsetzens des Bauelements 4 auf das Substrat 38. Nach Fig. 8 ist das Hubelement 19 noch weiter abgesenkt, wobei der Halter 5 mit dem Bauelement 4 in der Zwischenstellung gestoppt wurde. Nach Erreichen der voreingestellten Aufsetzkraft hat sich dabei das Spulenteil 34' vom Koppelteil 31' abgehoben, was zu einer rapiden Änderung des Magnetfelds und zu einem entsprechenden Ausschlag in der Stromzufuhr geführt hat, der durch den Stromsensor 42 detektiert worden ist, so dass damit der Moment des vollendeten Aufsetzens genau erfasst worden ist. Daraufhin wurde die Abwärtsbewegung des Hubaktors und bis zur dargestellten Umkehrposition gebremst, ohne dass sich dabei die Massenkräfte des Hubaktors auf die Aufsetzkraft auswirken konnten.

### Bezugszeichenliste

- z: senkrechte Richtung
- x, y: waagerechte Richtungen

- 1: Träger
- 2: Bestückkopf
- 3: Hubantrieb
- 4: Bauelement
- 5: Halter
- 6: Gehäuse
- 7: Klemmbügel
- 8: Magnetschiene
- 9: Spulenträger
- 10: Drehmotor
- 11: Antriebsteil
- 12: Koppelelement
- 13: Koppelfinger
- 14: Hubkörper
- 16: Ringnut
- 17: Stift
- 18: Drehlager
- 19: Hubelement
- 21: Rotor
- 22, 23: Wälzlager
- 24: Antriebswelle
- 26: Bohrung
- 27: Saugadapter
- 28: Basis
- 29: Freimachung
- 31,31': Koppelteil
- 32: Permanentmagnet
- 33: Stützelement
- 34,34': Spulenteil
- 36: O-Ring
- 37: Ankerteil
- 38: Substrat
- 39: Leiterplatte
- 41: Steuerelement
- 42: Sensor
- 43: Speicherelement
- 44: Elektronikchip
- 45: Mittelkugel
- 46: Stirnfläche
- 47: Schulter

## Patentansprüche

1. Bestückkopf (2) zum Bestücken von Substraten (38) mit elektrischen Bauelementen (4) in einer Bestückvorrichtung,
wobei der Bestückkopf einen Führungskörper für zumindest einen Halter (5) für die Bauelemente (4) aufweist, an dem der Halter (5) in einer zum Substrat (38) senkrechten Hubrichtung (z) verschiebbar gelagert ist,
wobei der Halter (5) aus einer oberen Halteposition in die Richtung des Substrats (38) nach unten verschiebbar ist,
wobei der Halter (5) mit einem relativ zu dem Führungskörper in der senkrechten Richtung (z) verschiebbaren Hubaktor (3, 14, 19) elektromagnetisch derart koppelbar ist, dass eine auf den Halter (5) nach unten gerichtete Hubkraft über eine magnetische Haftkraft übertragbar ist,
wobei die Haftkraft an einer Stirnfläche (46) eines beschaltbaren elektromagnetischen Spulenteils (34) wirkt, das durch den Hubaktor in der Hubrichtung verschiebbar ist, und
wobei an die Stirnfläche (46) ein am Halter (5) verankertes, ferromagnetisches Gegenstück anlegbar bzw. von der Stirnfläche (46) abhebbar ist,
und das Gegenstück als ferromagnetisches. am Halter (5) verankertes Koppelteil (31, 31) mit einer waagerecht abstehenden Schulter (47) ausgebildet ist, die an die nach oben weisende Stirnfläche (46) des Spulenteils (34 34') flach anlegbar ist, **dadurch gekennzeichnet,**
**dass** die Stromzufuhr zum Spulenteil (34, 34') durch eine elektrische Steuerung derart veränderbar ist, dass die durch das Spulenteil (34, 34') erzeugte magnetische Haftkraft vor dem Aufsetzen des Bauelementes (4) auf das Substrat (38) auf einen Wert einstellbar ist, der einer vorgegebenen Aufsetzkraft entspricht, so dass das ferromagnetische Gegenstück beim Aufsetzen des Bauelementes (4) auf das Substrat (38) von der Stirnfläche (46) abhebt.

2. Bestückkopf (2) nach Anspruch 1,
**dadurch gekennzeichnet,**
**dass** eine sich beim Zusammentreffen oder Trennen der Koppelverbindung ergebende Änderung des Magnetfeldes des Spulenteiles (34, 34') an dessen Stromzufuhr detektierbar ist.

3. Bestückkopf (2) nach Anspruch 1,
**dadurch gekennzeichnet,**
**dass** das ferromagnetische Koppelteil (31') und das Spulenteil (34') den Halter (5) mit der Schulter (46) vorzugsweise rotationssymmetrisch umschließen.

4. Bestückkopf (2) nach Anspruch 3,
**dadurch gekennzeichnet,**
**dass** das vorzugsweise zylindrische Koppelteil (31') mittels eines Kugelgelenks am Halter gelagert ist.

5. Bestückkopf (2) nach Anspruch 1,
**dadurch gekennzeichnet,**
**dass** das Spulenteil (34) neben dem Halter (5) angeordnet ist und
**dass** die Schulter an einer vom Halter (5) radial abstehenden Platte des Koppelteils (31) ausgebildet ist, die die Stirnfläche (46) des Spulenteils (34) überdeckt.

6. Bestückkopf (2) nach einem der vorhergehenden Ansprüche,
**dadurch gekennzeichnet,**
**dass** die Aufsetzkraft betreffende Kenndaten der Magnetkopplung in einem auslesbaren Datenspeicher des Bestückkopfes (2) gespeichert sind.

7. Bestückkopf (2) nach einem der vorhergehenden Ansprüche,
**dadurch gekennzeichnet,**
**dass** der Führungskörper mit Führungen für eine Mehrzahl der Halter (5) mit den Koppelteilen (31,31') versehen ist und
**dass** sich der Hubaktor über den gesamten Halterbereich erstreckt und mit einer Mehrzahl der den Koppelteilen (31,31') zugeordneten Spulenteile (34, 34') versehen ist.

8. Bestückkopf (2) nach Anspruch 7,
**dadurch gekennzeichnet,**
**dass** an einem Gehäuse (6) des Bestückkopfes ein Rotor (21) um eine zum Substrat (38) senkrechte Mittelachse (M) drehbar gelagert ist,
**dass** der Führungskörper fest mit dem Rotor (21) verbunden ist und
**dass** der Hubaktor ein sich quer zur Mittelachse (M) in sämtliche Halterbereiche erstreckendes Hubelement (19) aufweist, das mit dem Rotor (21) drehfest gekoppelt ist

9. Bestückkopf (2) nach Anspruch 8,
**dadurch gekennzeichnet,**
**dass** das Hubelement (19) an einem Hubkörper (14) des Hubaktors mittels eines zur Mittelachse (M) konzentrischen Drehlagers (18) drehbar gelagert ist und
**dass** der Hubkörper (14) am Gehäuse (6) drehfest in der senkrechten Richtung (z) verschiebbar gelagert ist.

10. Bestückkopf (2) nach einem der vorstehenden Ansprüche, wobei
der Halter (5) in seiner oberen Hubstellung durch Haltemittel lösbar gehalten ist.

11. Bestückkopf (2) nach Anspruch 10, wobei
die Haltemittel durch ein wechselweise am Halter (5) bzw. Führungskörper angebrachtes ferromagnetisches Ankerteil (37) und einen Permanentmagneten (32) gebildet sind und wobei
das Ankerteil (37) und der Permanentmagnet (32) in der oberen Hubstellung des Halters (5) einander angenähert sind.

12. Bestückkopf (2) nach Anspruch 10 oder 11,
**dadurch gekennzeichnet,**
**dass** der Permanentmagnet (32) und das Ankerteil 37) ringmagnetisch, in der oberen Haltestellung ineinandergreifend ausgebildet sind.

13. Vorrichtung zum Bestücken von Substraten (38) mit elektrischen Bauelementen (4),
mit einem Bestückkopf (2) nach einem der vorhergehenden Ansprüche,
mit einem Abholbereich für die Bauelemente (4),
mit einem Bestückfeld zum temporären Fixieren des Substrats (38) und
mit einem Positioniersystem zum Verschieben des Bestückkopfes (2) in einer zum Substrat (38) im Wesentlichen parallelen Führungsebene,
wobei der Bestückkopf (2) zumindest einen senkrecht zur Führungsebene verschiebbaren Halter (5) für das Bauelement (4) sowie einen Hubaktor zum Verschieben des Halters (5) aufweist,
wobei der Halter (5) und der Hubaktor mittels eines elektromagnetischen Spulenteils (34, 34') haftmagnetisch miteinander gekoppelt sind,
**dadurch gekennzeichnet,**
**dass** die Stromzufuhr zum Spulenteil (34, 34') mittels regelbarer Steuerelemente (41) derart veränderbar ist, dass die durch das Spulenteil (34, 34') erzeugte magnetische Haftkraft vor dem Aufsetzen des Bauelementes (4) auf das Substrat (38) auf einen Wert einstellbar ist, der einer vorgegebenen Aufsetzkraft entspricht.

14. Verfahren zum Betreiben eines Bestückkopfes nach einem der Ansprüche 1 bis 13,
wobei der Bestückkopf (2) einen Führungskörper für zumindest einen Halter (5) für elektrische Bauelemente (4) aufweist,
wobei der Halter (5) am Führungskörper in einer zum Substrat (38) senkrechten Hubrichtung (z) verschiebbar gelagert ist,
wobei der Halter (5) aus einer oberen Halteposition in die Richtung des Substrats (38) nach unten verschiebbar ist,
wobei der Halter (5) mit einem relativ zu dem Führungskörper in der senkrechten Richtung (z) verschiebbaren Hubaktor elektromagnetisch derart koppelbar ist, dass eine auf den Halter (5) nach unten gerichtete Hubkraft über eine magnetische Haftkraft übertragen wird,
wobei die Haftkraft an einer Stirnfläche (46) eines beschaltbaren elektromagnetischen Spulenteils (34, 34') wirkt, das durch den Hubaktor in der Hubrichtung verschiebbar ist und
wobei an die Stirnfläche (46) ein am Halter (5) verankertes ferromagnetisches Gegenstück angelegt bzw. von der Stirnfläche (46) abgehoben wird,
und das Gegenstück als ferromagnetisches. am Halter (5) verankertes Koppelteil (31, 31) mit einer waagerecht abstehenden Schulter (47) ausgebildet ist, die an die nach oben weisende Stirnfläche (46) des Spulenteils (34, 34') flach angelegt wird, **dadurch gekennzeichnet,**
**dass** die Stromzufuhr zum Spulenteil (34, 34') derart verändert wird, dass die durch das Spulenteil (34, 34') erzeugte magnetische Haftkraft vor dem Aufsetzen des Bauelementes (4) auf das Substrat (38) auf einen Wert eingestellt wird, der einer vorgegebenen Aufsetzkraft entspricht, so dass das ferromagnetische Gegenstück beim Aufsetzen des Bauelementes (4) auf das Substrat (38) von der Stirnfläche (46) des Spulenteils (34, 34') abgehoben wird;

## Claims

1. Placement head (2) for fitting substrates (38) with electrical components (4) in a placement device,
wherein the placement head comprises a guide body for at least one holder (5) for the components (4), on which the holder (5) is mounted displaceably in a stroke direction (z) perpendicular to the substrate (38),
wherein the holder (5) is downwardly displaceable from an upper holding position in the direction of the substrate (38),
wherein the holder (5) can be electromagnetically coupled with a stroke actuator (3, 14, 19) displaceable relative to the guide body in the perpendicular direction (z) such that a downwardly directed stroke force can be transmitted to the holder (5) by means of a magnetic holding force
wherein the holding force acts on an end face (46) of a switchable electromagnetic coil part (34), which is displaceable by the stroke actuator in the stroke direction, and
wherein a ferromagnetic counterpart piece fixed on the holder (5) can be applied to the end face (46) or lifted from the end face (46),
and the counterpart piece is configured as ferromagnetic, coupling part (31, 31') fixed on the holder (5) with a horizontally protruding shoulder (47), which can be applied evenly to the upwardly facing end face (46) of the coil part (34, 34'),
**characterised in that**
the power supply to the coil part (34, 34') can be varied by an electrical control unit such that the magnetic adhesive force produced by the coil part (34, 34') before the component (4) is placed on the substrate (38) can be adjusted to a value which corresponds to a predetermined contact force, so that the ferromagnetic counterpart piece lifts off the end face (46) when the component (4) is placed on the substrate (38).

2. Placement head (2) according to claim 1,
**characterised in that**
a variation of the magnetic field of the coil part (34, 34') during meeting or separating of the coupling connection can be detected at its power supply.

3. Placement head (2) according to claim 1,
**characterised in that**
the ferromagnetic coupling part (31') and the coil part (34') surround the holder (5) with the shoulder (46) preferably with rotational symmetry.

4. Placement head (2) according to claim 3,
**characterised in that**
the preferably cylindrical coupling part (31') is mounted on the holder with a ball joint.

5. Placement head (2) according to claim 1,
**characterised in that**
the coil part (34) is arranged next to the holder (5) and that the shoulder is formed on a plate of the coupling part (31) protruding radially from the holder (5) which covers the end face (46) of the coil part (34).

6. Placement head (2) according to any one of the preceding claims,
**characterised in that**
the characteristic data relating to the placement force of the magnetic coupling are stored in a readable data storage device of the placement head (2).

7. Placement head (2) according to any one of the preceding claims,
**characterised in that**
the guide body is provided with guides for a plurality of holders (5) with the coupling parts (31, 31') and
that the stroke actuator extends over the whole holder range and is provided with a plurality of coil parts (34, 34') associated with the coupling parts (31, 31').

8. Placement head (2) according to claim 7,
**characterised in that**
a rotor (21) rotatable about a central axis (M) perpendicular to the substrate (38) is mounted on a housing (6) of the placement head,
that the guide body is fixedly attached to the rotor (21) and
that the stroke actuator comprises a stroke member (19) extending perpendicular to the central axis (M) in all holder areas (19) that is coupled fixedly with the rotor (21).

9. Placement head (2) according to claim 8,
**characterised in that**
the stroke member (19) is rotatably mounted on a stroke body (14) of the stroke actuator by means of a rotary bearing (18) concentric to the central axis (M) and
that the stroke body (14) is fixedly mounted on the housing (6) displaceable in the vertical direction (z).

10. Placement head (2) according to any one of the preceding claims, wherein the holder (5) is releasably retained in its upper stroke position by retaining means.

11. Placement head (2) according to claim 10, wherein
the retaining means are formed by a ferromagnetic anchor part (37) alternately fixed on the holder (5) or guide body and a permanent magnet (32) and wherein
the anchor part (37) and the permanent magnet (32) are adjacent to each other in the upper stroke position of the holder (5).

12. Placement head (2) according to claim 10 or 11,
**characterised in that**
the permanent magnet (32) and the anchor part (37) are configured as magnetic ring, interlocking in the upper retaining position.

13. Device for fitting substrates (38) with electrical components (4),
with a placement head (2) according to any one of the preceding claims,
with a pick-up area for the components (4),
with a fitting area for temporary fixing the substrate (38) and
with a positioning system for displacing the placement head (2) in the guide plane substantially parallel to the substrate (38),
wherein the placement head (2) comprises at least one holder (5) for the component (4) displaceable perpendicular to the guide plane (5) and a stroke actuator for displacing the holder (5),
wherein the holder (5) and the stroke actuator are coupled to one another by magnetic adhesion by means of an electromagnetic coil part (34, 34'),
**characterised in that**
the power supply to the coil part (34, 34') can be varied by means of adjustable control elements (41) such that the magnetic adhesion force produced by the coil part (34, 34') can be adjusted before the component (4) is placed on the substrate (38) to a value which corresponds to a predetermined placing force.

14. Method for operating a placement head according to any one of claims 1 to 13,
wherein the placement head (2) has a guide head for at least one holder (5) for electrical components (4),
wherein the holder (5) is mounted displaceably in a stroke direction (z) perpendicular to the substrate (38),
wherein the holder (5) is downwardly displaceable from an upper holding position in the direction of the substrate (38),
wherein the holder (5) can be coupled electromagnetically with a stroke actuator displaceable in the vertical direction (z) relative to the guide body such that a downwardly directed stroke force is transmitted to the holder (5) by means of a magnetic adhesion force,
wherein the adhesion force acts on an end face (46) of an operable electromagnetic coil part (34, 34'), that is displaceable by the stroke actuator in the stroke direction and
wherein a ferromagnetic counterpart piece fixed to the holder (5) is applied to the end face (46) or lifted from the end face (46),
and the counterpart piece is configured as ferromagnetic coupling part (31, 31') fixed on the holder (5) with a horizontally protruding shoulder (47), which is applied evenly to the upwards facing end face (46) of the coil part (34, 34'),
**characterised in that**
the power supply to the coil part (34, 34') is varied so that the magnetic adhesion force produced by the coil part (34, 34') is adjusted before the component (4) is placed on the substrate (38) to a value which corresponds to a predetermined placing force, so that the ferromagnetic counterpart piece is lifted from the end face (46) of the coil part (34, 34') when the component (4) is placed on the substrate;

## Revendications

1. Tête d'implantation (2) pour implanter des composants électriques (4) sur des substrats (38), dans un dispositif d'implantation,
la tête d'implantation comportant un corps de guidage pour au moins une fixation (5) pour les composants (4), sur lequel ladite fixation (5) est montée pour pouvoir coulisser dans un sens de course (z) vertical par rapport au substrat (38),
la fixation (5) étant apte à coulisser vers le bas, à partir d'une position de fixation haute, en direction du substrat (38),
la fixation (5) étant apte à être couplée électromagnétiquement à un actionneur de course (3, 14, 19) apte à coulisser par rapport au corps de guidage dans le sens vertical (z), de telle sorte qu'une force de course exercée vers le bas sur la fixation (5) est apte à être transmise par l'intermédiaire d'une force d'adhérence magnétique,
la force d'adhérence agissant au niveau d'une surface frontale (46) d'un élément de bobine électromagnétique commutable (34) qui est apte à coulisser dans le sens de course grâce à l'actionneur de course, et
un élément ferromagnétique opposé, ancré sur la fixation (5), étant apte à être appliqué contre la surface frontale (46) et détaché de celle-ci,
et ledit élément opposé étant conçu comme un élément de couplage ferromagnétique (31, 31) ancré sur la fixation (5) et pourvu d'un épaulement (47) saillant horizontalement qui est apte à être appliqué à plat contre la surface frontale (46), dirigée vers le haut, de l'élément de bobine (34, 34'),
**caractérisée en ce que** l'alimentation en courant de l'élément de bobine (34, 34') est apte à être modifiée par une commande électrique de telle sorte que la force d'adhérence magnétique générée par l'élément de bobine (34, 34') soit réglable, avant la pose du composant sur le substrat (38), à une valeur correspondant à une force de pose prédéfinie, de sorte que l'élément ferromagnétique opposé se détache de la surface frontale lors de la pose du composant (4) sur le substrat (38).

2. Tête d'implantation (2) selon la revendication 1, **caractérisée en ce qu'**une variation du champ magnétique de l'élément de bobine (34, 34') qui survient lors de la réalisation ou de la suppression de la liaison par couplage est détectable au niveau de l'alimentation électrique dudit élément de bobine (34, 34').

3. Tête d'implantation (2) selon la revendication 1, **caractérisée en ce que** l'élément ferromagnétique de couplage (31') et l'élément de bobine (34') entourent la fixation (5) avec l'épaulement (46) de préférence avec une symétrie de révolution.

4. Tête d'implantation (2) selon la revendication 3, **caractérisée en ce que** l'élément de couplage (31') de préférence cylindrique est monté sur la fixation à l'aide d'un joint à rotule.

5. Tête d'implantation (2) selon l'une des revendications précédentes,
**caractérisée en ce que** l'élément de bobine (34) est disposé près de la fixation (5), et
**en ce que** l'épaulement est formé sur une plaque de l'élément de couplage (31) qui dépasse radialement de la fixation (5) et qui recouvre la surface frontale (46) de l'élément de bobine (34).

6. Tête d'implantation (2) selon l'une des revendications précédentes,
**caractérisée en ce que** des caractéristiques du couplage magnétique qui concernent la force de pose sont stockées dans une mémoire de données, apte à être lue, de la tête d'implantation (2).

7. Tête d'implantation (2) selon l'une des revendications précédentes,
**caractérisée en ce que** le corps de guidage est pourvu de guides pour plusieurs fixations (5) avec les éléments de couplage (31, 31'), et
**en ce que** l'actionneur de course s'étend sur toute la zone de fixation et est pourvu de plusieurs éléments de bobine (34, 34') associés aux éléments de couplage (31, 31').

8. Tête d'implantation (2) selon la revendication 7, **caractérisée en ce que** sur un boîtier (6) de la tête d'implantation, un rotor (21) est monté pivotant sur un axe central (M) vertical par rapport au substrat (38),
**en ce que** le corps de guidage est relié de manière fixe au rotor (21), et
**en ce que** l'actionneur de course comporte un élément de course (19) qui s'étend transversalement par rapport à l'axe central (M) dans toutes les zones d'attaches, et qui est couplé, fixe en rotation, au rotor (21).

9. Tête d'implantation (2) selon la revendication 8, **caractérisée en ce que** l'élément de course (19) est monté pivotant sur un corps de course (14) de l'actionneur de course à l'aide d'un palier (18) concentrique par rapport à l'axe central (M), et
**en ce que** le corps de course (14) est monté, fixe en rotation, sur le boîtier (6) de manière à pouvoir coulisser dans le sens vertical (z).

10. Tête d'implantation (2) selon l'une des revendications précédentes, **caractérisée en ce que** la fixation (5) est maintenue de manière amovible dans sa position de course haute à l'aide de moyens de retenue.

11. Tête d'implantation (2) selon la revendication 10,
les moyens de retenue étant formés par un élément d'induit ferromagnétique (37) installé en alternance sur la fixation (5) ou sur le corps de guidage, et par un aimant permanent (32), et
l'élément d'induit (37) et l'aimant permanent (32) étant approchés l'un de l'autre dans la position de course haute de la fixation (5).

12. Tête d'implantation (2) selon la revendication 10 ou 11,
**caractérisée en ce que** l'aimant permanent (32) et l'élément d'induit (37) ont la forme d'aimants annulaires et s'emboîtent l'un dans l'autre dans la position haute.

13. Dispositif pour implanter des composants électriques (4) sur des substrats (38),
avec une tête d'implantation (2) selon l'une des revendications précédentes,
avec une zone d'enlèvement pour les composants (4), avec une zone d'implantation pour la fixation temporaire du substrat (38), et
avec un système de positionnement pour faire coulisser la tête d'implantation (2) dans un plan de guidage globalement parallèle au substrat (38),
la tête d'implantation (2) comportant au moins une fixation (5) apte à coulisser perpendiculairement au plan de guidage, pour le composant (4), ainsi qu'un actionneur de course pour faire coulisser la fixation (5),
la fixation (5) et l'actionneur étant couplés par adhérence magnétique à l'aide d'un élément de bobine électromagnétique (34, 34'),
**caractérisé**
**en ce que** l'alimentation en courant de l'élément de bobine (34, 34') est apte à être modifiée à l'aide d'une commande électrique régulable (41) de telle sorte que la force d'adhérence magnétique générée par l'élément de bobine (34, 34') soit réglable, avant la pose du composant (4) sur le substrat (38), à une valeur correspondant à une force de pose prédéfinie.

14. Procédé pour faire fonctionner une tête d'implantation selon l'une des revendications 1 à 13,
la tête d'implantation (2) comportant un corps de guidage pour au moins une fixation (5) pour des composants électriques (4), sur lequel ladite fixation (5) est montée pour pouvoir coulisser dans un sens de course (z) vertical par rapport au substrat (38),
la fixation (5) étant montée sur le corps de guidage pour pouvoir coulisser vers le bas, à partir d'une position de fixation haute, en direction du substrat (38),
la fixation (5) étant apte à être couplée électromagnétiquement à un actionneur de course apte à coulisser par rapport au corps de guidage dans le sens vertical (z), de telle sorte qu'une force de course exercée vers le bas sur la fixation (5) est transmise par l'intermédiaire d'une force d'adhérence magnétique,
la force d'adhérence agissant au niveau d'une surface frontale (46) d'un élément de bobine électromagnétique commutable (34, 34') qui est apte à coulisser dans le sens de course grâce à l'actionneur de course, et
un élément ferromagnétique opposé, ancré sur la fixation (5), étant apte à être appliqué contre la surface frontale (46) et détaché de celle-ci,
et ledit élément opposé étant conçu comme un élément de couplage ferromagnétique (31, 31) ancré sur la fixation (5) et pourvu d'un épaulement (47) saillant horizontalement qui est apte à être appliqué à plat contre la surface frontale (46), dirigée vers le haut, de l'élément de bobine (34, 34'),
**caractérisé en ce que** l'alimentation en courant de l'élément de bobine (34, 34') est apte à être modifiée de telle sorte que la force d'adhérence magnétique générée par l'élément de bobine (34, 34') soit réglable, avant la pose du composant sur le substrat (38), à une valeur correspondant à une force de pose prédéfinie, de sorte que l'élément ferromagnétique opposé est détaché de la surface frontale lors de la pose du composant (4) sur le substrat (38).
